# EUROPÄISCHE PATENTSCHRIFT

(11) **EP 0 806 492 B1**
(45) Veröffentlichungstag und Bekanntmachung des Hinweises auf die Patenterteilung: **09.08.2000**
(21) Anmeldenummer: 97107376.2
(22) Anmeldetag: 05.05.1997
(51) Int. Cl.: C23C 14/50

(54) **Substrat-Träger für vakuum-Beschichtungsanlagen**
Substrate holder for vacuum coating apparatus
Porte-substrat pour dispositif de revêtement sous vide

(30) Priorität: 10.05.1996 CH 120096
(43) Veröffentlichungstag der Anmeldung: 12.11.1997
(73) Patentinhaber: Satis Vacuum Industries Vertriebs - AG, 8700 Küsnacht (CH)
(72) Erfinder: Suter, Rudolf, 6048 Horw (CH)
(74) Vertreter: Petschner, Goetz

(56) Entgegenhaltungen:
- US-A- 3 859 956
- PATENT ABSTRACTS OF JAPAN vol. 010, no. 321 (C-382), 31.Oktober 1986 & JP 61 130484 A (OLYMPUS OPTICAL CO LTD), 18.Juni 1986,

## Beschreibung

Die vorliegende Erfindung betrifft einen Substrat-Täger für Vakuum-Beschichtungsanlagen zum Aufdampfen von Vergütungsschichten auf Flächen optischer Substrate, wie Kunststoff-Brillengläser, welche auf eine Mehrzahl solcher Träger aufspannbar sind, die sich in einem evakuierbaren Rezipienten oberhalb von auswechselbaren Verdampfungsquellen befinden.

Bei bekannten Einrichtungen dieser Art zum Aufdampfen von mindestens einer Oberflächenschicht auf optische Substrate, insbesondere Brillengläser, im Vakuum, werden eine vorgegebene Anzahl solcher Substrate nach dem Aufdampfen von in der Regel mehreren Schichten aus der Ebene, in welcher die Substratflächen der Wirkung der auswechselbaren Verdampfungsquellen ausgesetzt waren, herausbewegt und nochmals eine gleiche Anzahl Substratflächen in diese Ebene hineinbewegt, um diese ebenfalls nachfolgend einmal oder mehrmals zu bedampfen.

Hierfür ist beispielsweise ein unter Vakuum setzbarer Drehtisch gebräuchlich, an dessen Umfang eine Mehrzahl Stationen zur lösbaren Befestigung von Substraten angeordnet sind. Diese Einrichtung umfasst weiter mindestens eine, mit den zugewendeten Substratflächen in Wirkungsverbindung stehende Verdampfungsquelle. Hierbei ist jede Station mit einem Substrat-Träger bestückt, an dem sich Haltemittel für die lösbare Befestigung von jeweils einem Substrat befinden. Sind dann auf den Substratflächen der einen Seite die einzelnen Vergütungsschichten nacheinander aufgedampft, werden die Substrat-Träger durch Rotation des Drehtisches gewendet und dann die anderen Substratflächen bedampft.

Ferner ist es bekannt, Substrat-Träger als sogenannte Kalotten auszubilden, um eine Mehrzahl Substrate auf die flächigen, kreissegmentförmigen Träger aufzubringen. Eine Mehrzahl solcher Kalotten erstrecken sich jeweils kuppelförmig und drehbar im oberen Teil des Rezipienten, wodurch dann mit jeder Kalotte eine Mehrzahl Substrate jeweils gleichzeitig gewendet werden können.

Problematisch bei solchen Anordnungen ist, dass der zentrisch im Rezipienten kegelförmig aufsteigende Bedampfungsstrahl eine genaue Winkelstellung der zu bedampfenden Substratflächen zum Strahlenkegel erfordert, um auf jeder Fläche einen optimalen, gleichförmigen Niederschlag zu erreichen.

Dies ist bei einer Anordnung der radial von einem Drehtisch abragenden und um 180° über eine Achse wendbaren Substrat-Träger mit jeweils einem Substrat durch Schrägstellung der Achsen ohne weiteres erreichbar.

Bei den kalottenförmigen Substrat-Trägern, bei denen eine Mehrzahl Substrate auf die flächigen, kreissegmentförmigen Träger aufzubringen sind, ist dies aber nicht ohne weiteres ausreichend.

Bei diesen kalottenförmigen Substrat-Trägern wurden deshalb schon Substrathalterungen an den Trägern vorgesehen, die mit dem Substrat nach beiden Seiten aus der Trägerplattenebene bis zu einem vorgegebenen Winkel heraus frei kippbar sind.

Solche Substrathalterungen an den Trägern sind allerdings sehr kompliziert und störanfällig.

Es ist deshalb Aufgabe der vorliegenden Erfindung, Substrat-Träger der vorgenannten Art so auszugestalten, dass diese in sehr einfacher Weise die zu bedampfenden Substratflächen immer in eine genaue Winkelstellung zum zentrisch im Rezipienten kegelförmig aufsteigende Bedampfungsstrahl bringen, um auf jeder Fläche einen optimalen, gleichförmigen Niederschlag zu erreichen.

Dies wird bei einem Substrat-Täger für Vakuum-Beschichtungsanlagen zum Aufdampfen von Vergütungsschichten auf Flächen optischer Substrate, wie Kunststoff-Brillengläser, welche auf eine Mehrzahl solcher Träger aufspannbar sind, die sich in einem evakuierbaren Rezipienten oberhalb von auswechselbaren Verdampfungsquellen befinden, dadurch erreicht, dass in radialer Ausdehnung des Substrat-Trägers mindestens zwei Aufnahmebereiche für jeweils ein Substrat vorgesehen sind, zwischen welchen Aufnahmebereichen sich jeweils ein, den Substrat-Träger in Abschnitte unterteilendes Scharnier oder Gelenk befindet, um das die Substrat-Träger-Abschnitte mit dem Substrat nach beiden Seiten hin relativ zueinander bis zu einem vorgegebenen Winkel frei kippbar sind.

Unabhängig der Form des Substrat-Trägers und unabhängig seiner Anzahl durch Scharniermittel oder Gelenkmittel unterteilter, Substrate tragender Abschnitte ist es nunmehr möglich, dass, nach jedem Verdrehen der Substrat-Träger um 180°, die zu bedampfenden Substratflächen immer in eine genaue Winkelstellung zum zentrisch im Rezipienten kegelförmig aufsteigenden Bedampfungsstrahl gelangen, wodurch auf jeder Substratfläche ein optimaler, gleichförmiger Niederschlag erreicht wird.

Eine bevorzugte Ausgestaltung ist dann möglich durch mindestens zwei, sich radial erstreckende und an der Drehachse anschliessende Abschnitte, welche aus kreisförmigen Halteteilen für die Substrate bestehen und welche durch Scharniere oder Gelenke verbunden sind, um welche die Substrat-Träger-Abschnitte mit dem Substrat nach beiden Seiten hin relativ zueinander bis zu einem vorgegebenen Winkel frei kippbar sind; oder durch eine kalottenförmige Platte, die in mindestens zwei Abschnitte durch Gelenkmittel unterteilt ist, um welche die Substrat-Träger-Abschnitte mit dem Substrat nach beiden Seiten hin relativ zueinander bis zu einem vorgegebenen Winkel frei kippbar sind, wobei mindestens der mittlere Abschnitt Mittel zur Aufnahme von mindestens zwei nebeneinanderliegenden Substraten aufweist; oder durch eine streifenförmige Anordnung, die in mindestens zwei Aufnahmebereiche für jeweils ein Substrat aufgeteilt ist, zwischen welchen Aufnahmebereichen sich jeweils ein, den Substrat-Träger in Abschnitte unterteilendes Scharnier oder Gelenk befindet, um welches die Substrat-Träger-Abschnitte mit dem Substrat nach beiden Seiten hin relativ zueinander bis zu einem vorgegebenen Winkel frei kippbar sind.

Beispielsweise Ausführungsformen des Erfindungsgegenstandes sind nachfolgend anhand der Zeichnung näher erläutert. Es zeigen:
- Fig. 1: in schematischer, vereinfachter Darstellung in Seitenansicht eine Vakuum-Beschichtungsanlage mit erfindungsgemässen Substrat-Trägern;
und
- Fig. 2 bis 4: in Draufsicht und in grösserem Massstab Ausführungsformen von erfindungsgemässen Substrat-Trägern.

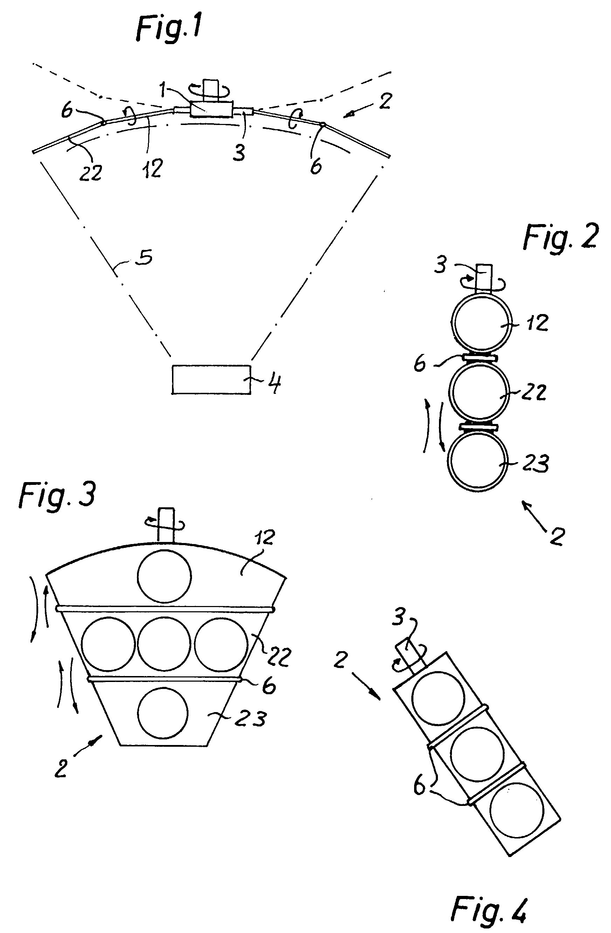

Die in Fig. 1 angedeutete Vakuum-Beschichtungsanlage zum Aufdampfen von Vergütungsschichten auf optische Substrate, beispielsweise Kunststoff-Brillenglaser, umfasst einen, über eine Vakuum-Pumpe evakuierbaren, ansich bekannten Rezipienten (nicht gezeigt).

Im oberen Kammerbereich dieses Rezipienten befindet sich eine sogenannte Wendeträger-Vorrichtung 1 mit einer Mehrzahl, hier zwei erkennbare radial um die kreisförmige Wendeträger-Vorrichtung 1 angeordnete, erfindungsgemässe Substrat-Träger 2, die je an einer, temporär um 180° verdrehbaren Drehachse 3 abgestützt sind, wobei jeder Substrat-Träger 2 Mittel zum klemmenden Festhalten eines beidseitig zu beschichtenden Substrates oder zum Festhalten von zwei einseitig zu beschichtenden Substraten umfasst (nicht gezeigt).

Die erfindungsgemässen Substrat-Träger 2 werden nachfolgend noch näher beschrieben.

Im unteren Bereich des Rezipienten ist eine zentrische Verdampfungsquelle 4 angedeutet, die in bekannter Weise einen kegelförmigen Bedampfungsstrahl 5 erzeugt zum Bedampfen der Flächen der von den Substrat-Trägern 2 gehaltenen Substrate.

Um nun die zu bedampfenden Substratflächen der Substrate nach jedem Verdrehen der Substrat-Träger 2 um 180° immer in eine genaue Winkelstellung zum zentrisch im Rezipienten kegelförmig aufsteigenden Bedampfungsstrahl zu bringen, um auf jeder Substratfläche einen optimalen, gleichförmige Niederschlag zu erreichen, sind erfindungsgemäss in radialer Ausdehnung des Substrat-Trägers 2 mindestens zwei Aufnahmebereiche für jeweils ein Substrat vorgesehen, zwischen welchen Aufnahmebereichen sich jeweils ein, den Substrat-Träger in Abschnitte 12,22 unterteilendes Scharnier oder Gelenk 6 befindet, um das die Substrat-Träger-Abschnitte mit dem Substrat nach beiden Seiten hin relativ zueinander bis zu einem vorgegebenen Winkel heraus frei kippbar sind, wie das in Fig. 1 durch die gestrichelte Linie angedeutet ist.

Unabhängig der Form des Substrat-Trägers 2 und unabhängig seiner Anzahl durch Scharniermittel oder Gelenkmittel 6 unterteilter, Substrate tragender Abschnitte 12,22 ist es nunmehr möglich, dass die zu bedampfenden Substratflächen immer in eine genaue Winkelstellung zum zentrisch im Rezipienten kegelförmig aufsteigenden Bedampfungsstrahl 5 gelangen, wodurch auf jeder Substratfläche ein optimaler, gleichförmiger Niederschlag erreicht wird, wie das Fig. 1 erkennen lässt.

Bei der Ausführungsvariante eines Substrat-Trägers 2 gemäss Fig. 2 sind drei, sich radial erstreckende und an der Drehachse 3 anschliessende Abschnitte 12, 22 und 23 vorgesehen, welche aus kreisförmigen Halteteilen für die Substrate bestehen und welche hier durch zwei Scharniere oder Gelenke 6 verbunden sind.

Bei der Ausführungsvariante eines Substrat-Trägers 2 gemäss Fig. 3 besteht der Substrat-Träger 2 aus einer kalottenförmigen Platte, die ebenfalls in drei Abschnitte 12, 22 und 23 durch Gelenkmittel 6 unterteilt ist, wobei der mittlere Abschnitt 22 hier Mittel zur Aufnahme von drei nebeneinanderliegenden Substraten aufweist.

Je nach relativer Grösse der Substrate zum kalottenförmigen Substrat-Träger 2 können natürlich auch noch mehr Substrate aufbringbar sein.

Bei der Ausführungsvariante eines Substrat-Trägers 2 gemäss Fig. 4 ist ein streifenförmiger Substrat-Träger 2 in drei Aufnahmebereiche für jeweils ein Substrat vorgesehen, zwischen welchen Aufnahmebereichen sich jeweils ein, den Substrat-Träger in Abschnitte 12, 22 und 23 unterteilendes Scharnier oder Gelenk 6 befindet, um welches die Substrat-Träger-Abschnitte mit dem Substrat nach beiden Seiten hin relativ zueinander bis zu einem vorgegebenen Winkel frei kippbar sind.

Aus dem Vorstehenden ergibt sich, dass die Form der Substrat-Träger unterschiedlich sein kann, soweit diese gestattet, dass die Substrat-Träger-Abschnitte mit dem Substrat nach beiden Seiten hin relativ zueinander bis zu einem vorgegebenen Winkel frei kippbar sind.

Es wird Schutz beansprucht wie folgt:

## Patentansprüche

1. Substrat-Täger für Vakuum-Beschichtungsanlagen zum Aufdampfen von Vergütungsschichten auf Flächen optischer Substrate, wie Kunststoff-Brillengläser, welche auf eine Mehrzahl solcher Träger aufspannbar sind, die sich in einem evakuierbaren Rezipienten oberhalb von auswechselbaren Verdampfungsquellen befinden,
dadurch gekennzeichnet, dass
in radialer Ausdehnung des Substrat-Trägers (2) mindestens zwei Aufnahmebereiche für jeweils ein Substrat vorgesehen sind, zwischen welchen Aufnahmebereichen sich jeweils ein, den Substrat-Träger (2) in Abschnitte (12,22) unterteilendes Scharnier oder Gelenk (6) befindet, um welches die Substrat-Träger-Abschnitte mit dem Substrat nach beiden Seiten hin relativ zueinander bis zu einem vorgegebenen Winkel frei kippbar sind.

2. Substrat-Täger nach Anspruch 1, gekennzeichnet durch mindestens zwei, sich radial erstreckende und an der Drehachse (3) anschliessende Abschnitte (12, 22 und 23), welche aus kreisförmigen Halteteilen für die Substrate bestehen und welche durch Scharniere oder Gelenke (6) verbunden sind, um welche die Substrat-Träger-Abschnitte mit dem Substrat nach beiden Seiten hin relativ zueinander bis zu einem vorgegebenen Winkel frei kippbar sind.

3. Substrat-Täger nach Anspruch 1, gekennzeichnet durch eine kalottenförmige Platte, die in mindestens zwei Abschnitte (12, 22 und 23) durch Gelenkmittel (6) unterteilt ist, um welche die Substrat-Träger-Abschnitte mit dem Substrat nach beiden Seiten hin relativ zueinander bis zu einem vorgegebenen Winkel frei kippbar sind, wobei mindestens der mittlere Abschnitt (22) Mittel zur Aufnahme von mindestens zwei nebeneinanderliegenden Substraten aufweist.

4. Substrat-Täger nach Anspruch 1, gekennzeichnet durch eine streifenförmige Anordnung, die in mindestens zwei Aufnahmebereiche für jeweils ein Substrat aufgeteilt ist, zwischen welchen Aufnahmebereichen sich jeweils ein, den Substrat-Träger in Abschnitte (12, 22 und 23) unterteilendes Scharnier oder Gelenk (6) befindet, um welches die Substrat-Träger-Abschnitte mit dem Substrat nach beiden Seiten hin relativ zueinander bis zu einem vorgegebenen Winkel frei kippbar sind.

## Claims

1. Substrate holder for vacuum coating apparatus, designed for the vacuum evaporation of antireflection coatings onto optical substrate surfaces, such as plastic spectacle lenses, which can be clamped onto a plurality of such holders, located above replaceable evaporation sources in a container that can be evacuated,
characterized in that
at least two receiving regions for one each substrate are provided in radial extension of the substrate holder (2), between which receiving regions respectively one hinge or joint (6) is located, which subdivides the substrate holder (2) into segments (12, 22) and around which the substrate holder segments with the substrate can be swiveled freely toward both sides, relative to each other and up to a predetermined angle.

2. Substrate holder according to Claim 1, characterized by at least two, radially extending segments (12, 22 and 23) that adjoin the rotational axis (3), which consist of circular holders for the substrates and are connected by hinges or joints (6), around which the substrate holder segments with the substrate can be swiveled freely toward both sides, relative to each other and up to a predetermined angle.

3. Substrate holder according to Claim 1, characterized by a calotte-shaped plate, which is subdivided into at least two segments (12, 22 and 23) by hinged means (6), around which the substrate holder segments with the substrate can be swiveled freely toward both sides, relative to each other and up to a predetermined angle, wherein at least the center segment (22) has means for receiving at least two side-by-side arranged substrates.

4. Substrate holder according to Claim 1, characterized by a strip-type arrangement, divided into at least two receiving regions for one each substrate, between which receiving regions one each hinge or joint (6) is located that subdivides the substrate holder into segments (12, 22 and 23) and around which the substrate holder segments can be swiveled freely toward both sides, relative to each other and up to a predetermined angle.

## Revendications

1. Porte-substrat pour des installations de revêtement sous vide pour vaporiser des couches de revêtement sur des faces de substrats optiques, comme des verres de lunettes en matière synthétique qui peuvent être tendus sur plusieurs de ces supports qui se trouvent dans un récipient pouvant être évacué au-dessus de sources d'évaporation échangeables, caractérisé en ce que sont prévus dans l'extension radiale du porte-substrat (2) au moins deux zones de réception pour respectivement un substrat, où se trouve entre ces zones de réception respectivement une charnière ou articulation (6) subdivisant le porte-substrat (2) en sections (12, 22), autour de laquelle les sections de porte-substrat peuvent être basculées librement avec le substrat vers les deux côtés l'une relativement à l'autre jusqu'à un angle prédéterminé.

2. Porte-substrat selon la revendication 1, caractérisé par au moins deux sections (12, 22 et 23) s'étendant radialement et faisant suite à l'axe de rotation (3), qui sont constitués de parties de retenue circulaires pour les substrats et qui sont reliées par des charnières ou articulations (6) autour desquelles les sections de porte-substrat peuvent être basculées librement avec le substrat selon les deux côtés les unes relativement aux autres jusqu'à un angle prédéterminé.

3. Porte-substrat selon la revendication 1, caractérisé par une plaque en forme de calotte qui est subdivisée en au moins deux sections (12, 22 et 23) par des moyens d'articulation (6) autour desquels les sections de porte-substrat peuvent être basculées librement avec le substrat vers les deux côtés les unes relativement aux autres jusqu'à un angle prédéterminé, où au moins la section médiane (22) présente des moyens pour recevoir au moins deux substrats situés l'un à côté de l'autre.

4. Porte-substrat selon la revendication 1, caractérisé par un agencement en forme de bande qui est subdivisé en au moins deux zones de réception pour respectivement un substrat, où entre ces zones de réception se trouve respectivement une charnière ou articulation (6) subdivisant le porte-substrat en sections (12, 22 et 23), autour de laquelle les sections de porte-substrat peuvent être basculées librement avec le substrat vers les deux côtés les unes relativement aux autres jusqu'à un angle prédéterminé.
